**Europäisches Patentamt**

**European Patent Office**

**Office européen des brevets**

(19)

(11) **EP 0 960 341 B1**

(12) **EUROPÄISCHE PATENTSCHRIFT**

| | |
|---|---|
| (45) Veröffentlichungstag und Bekanntmachung des Hinweises auf die Patenterteilung: **26.09.2001 Patentblatt 2001/39** | (51) Int Cl.⁷: **G01R 15/18** |
| (21) Anmeldenummer: **98910606.7** | (86) Internationale Anmeldenummer: **PCT/DE98/00379** |
| (22) Anmeldetag: **11.02.1998** | (87) Internationale Veröffentlichungsnummer: **WO 98/36282 (20.08.1998 Gazette 1998/33)** |

(54) **STROMSENSOR NACH DEM KOMPENSATIONSPRINZIP**

CURRENT DETECTOR WORKING IN ACCORDANCE WITH THE COMPENSATION PRINCIPLE

DETECTEUR DE COURANT FONCTIONNANT SELON LE PRINCIPE DE COMPENSATION

| | |
|---|---|
| (84) Benannte Vertragsstaaten: **CH DE FR GB LI SE** | (72) Erfinder: **LENHARD, Friedrich** **D-63452 Hanau (DE)** |
| (30) Priorität: **14.02.1997 DE 19705768** | (74) Vertreter: **Patentanwälte** **Westphal, Mussgnug & Partner** **Waldstrasse 33** **78048 Villingen-Schwenningen (DE)** |
| (43) Veröffentlichungstag der Anmeldung: **01.12.1999 Patentblatt 1999/48** | |
| (73) Patentinhaber: **Vacuumschmelze GmbH** **63450 Hanau (DE)** | (56) Entgegenhaltungen: **DE-U- 29 520 066 FR-A- 2 692 991** **US-A- 5 565 765** |

## Beschreibung

Die Erfindung betrifft einen Stromsensor nach dem Kompensationsprinzip, bei dem das von einer vom zu messenden Strom durchflossenen Primärwicklung erzeugte Magnetfeld durch den Kompensationsstrom in einer Sekundärwicklung kompensiert wird und bei dem zur Steuerung des Kompensationsstromes mindestens ein vom Magnet feld beeinflußter Sensor Abweichungen vom Nullfluß erfaßt und diesen Meßwert einer Treiberschaltung zur Erzeugung des Kompensationsstromes zuführt, wobei an den Ausgang der Treiberschaltung die Sekundärwicklung in Reihe zu einem Abschlußwiderstand angeschlossen ist und am Abschlußwiderstand eine dem zu messenden Strom proportionale Spannung anliegt.

Ein derartiger Stromsensor nach dem Kompensationsprinzip ist. beispielsweise aus der EP 356 248 und der EP 691 544 (= US-A- 5 565 765) sowie der DE-U- 295 20 066 bekannt und in Figur 5 der Zeichnung dargestellt. Der zu messende Strom $i_1$ fließt dabei durch die Primärwicklung 1 eines Stromtransformators, der beispielsweise einen Magnetkern 2 sowie einen den Magnetfluß im Magnetkern 2 messenden Sensor 3 aufweist.

Der Sensor 3 besteht zum Beispiel aus einem in die Sättigung gesteuerten Transformator mit rechteckförmiger Magneti-sierungskennlinie. Die Ausgangsspannung des Sensors 3 wird in einer nachgeschalteten Auswerteschaltung 4 aufbereitet, der wiederum eine Treiberschaltung 5 nachgeschaltet ist. Der Ausgang der Treiberschaltung 5 ist über die Sekundärwicklung 6 des Stromtransformators und einen Abschlußwiderstand 7 mit einem Bezugspotential G verbunden.

Der zu messende Strom erzeugt nun über die Primärwicklung 1 einen magnetischen Fluß im Magnetkern 2, der vom Sensor 3 erfaßt wird. Die dem Sensor 3 nachgeschaltete Auswerteschaltung 4 liefert ein von der Größe und Richtung des Magnetfeldes im Magnetkern 2 abhängiges Signal an die Treiberschaltung 5, die einen Kompensationsstrom $i_2$ durch die Sekundärwicklung 6 treibt. Der Kompensationsstrom $i_2$ ist so gerichtet, daß sein Magnetfeld den Magnetfluß im Magnetkern 2 kompensiert. Der Strom in der Sekundärwicklung 6 wird vom Sensor 3 in Verbindung mit der Auswerteschaltung 4, der Treiberschaltung 5 sowie der Sekundärwicklung 6 so lange geändert, bis das Magnetfeld im Magnetkern 2 zu Null wird. Damit ist der Strom $i_2$ in der Sekundärwicklung 6 ein Maß für den Augenblickswert des zu messenden Stromes $i_1$ in der Primär-wicklung 1, wobei sowohl Gleich- als auch Wechselströme erfaßt werden können. Der Strom $i_2$ fließt außerdem.über einen Abschlußwiderstand 7, an dem die Ausgangsspannung Ua des Stromsensors abfällt, die dadurch in Größe und Phasenlage dem zu messenden Strom $i_1$ in der Primärwicklung 1 entspricht.

Der maximal meßbare Strom $i_{1max}$ des Kompensationsstromsensors ist dabei:

$$i_{1max} = W_2 \cdot (U_V - U_B)/R_i + R_a),$$

wobei $w_2$. gleich der Sekundärwindungszahl, $U_V$ gleich der Versorgungsspannung, $U_B$ gleich dem Spannungsabfall in der Treiberstufe 5, $R_i$ gleich dem Innenwiderstand der Sekundärwicklung 6 und $R_a$ gleich dem Widerstandswert des Abschlußwiderstandes 7 ist.

Die bekannten Kompensationsstromsensoren arbeiten überwiegend mit einem Abschlußwiderstand, der in Reihe mit der Sekundärwicklung gegen ein Bezugspotential geschaltet ist. Dadurch wird zur Kompensation eines positiven Stromes eine positive (bzw.negative) Versorgungsspannung und zur Kompensation eines negativen Stromes eine negative (bzw. positive) Versorgungsspannung benötigt. Folglich muß eine bipolare Spannungsversorgung vorgesehen werden. Steht eine solche nicht zur Verfügung, so können zwar aus einer unipolaren Spannungsquelle durch Spannungshalbierung zwei bipolare Spannungen gewonnen werden, jedoch halbieren sich damit auch deren einzelne Spannungswerte. Aufgrund der halben Spannungswerte verringert sich gemäß obiger Gleichung aber auch der maximal meßbare Strom.

Aufgabe der Erfindung ist es, einen nach dem Kompensationsprinzip arbeitenden Stromsensor mit unipolarer Spannungsversorgung anzugeben, der diese Nachteile nicht aufweist.

Die FR-A- 2 692 991 offenbart zwar einen Meßsensor mit unipolarer Versorgungsspannung; bei dem aber je nach Richtung des Primärstroms das Spannungssignal an einem der beiden Abschluß widerstände abgegriffes werden muß.

Die Aufgabe wird durch einen Stromsensor gemäß Patentanspruch 1 gelöst. Ausgestaltungen und Weiterbildungen des Erfindungsgedankens sind Gegenstand von Unteransprüchen.

Erfindungsgemäß wird der eingangs genannte Stromsensor derart weitergebildet, daß als Treiberschaltung zwei durch den Meßwert angesteurte, einander gegenüber gegenphasige Ausgangssignale liefernde Verstärker in Brückenschaltung verwendet werden, wobei zwischen die Ausgänge der Verstärker und die Reihenschaltung aus Sekundärwicklung und Abschlußwiderstand geschaltet ist.

Bevorzugt werden zwei in Brückenschaltung betriebene Gegentaktendstufen vorgesehen. Der Meßwert des Sensors wird dabei den beiden in Brükkenschaltung betriebenen Gegentaktendstufen mittelbar oder unmittelbar zugeführt. Die Ausgänge der beiden Gegentaktendstufen, zwischen die die Reihenschaltung aus Sekundärwicklung und Abschlußwiderstand geschaltet ist, liefern dabei zueinander gegenphasige Signale. Die Gegenphasigkeit kann beispielsweise dadurch erzielt werden, daß beide Gegentaktendstufen durch das gleiche, jeweils den Meßwert repräsentierende Signal angesteuert werden, wobei eine der Gegentaktendstufen invertierend und die andere nichtinvertierend ausgeführt ist. Alternativ können beide Gegentaktendstufen gleichphasige Übertragungseigenschaften aufweisen, jedoch gegenphasig angesteuert werden. Der Vorteil dabei ist, daß bei einer unipolaren Versorgungsspannung sowohl positive wie auch negative Kompensationsströme erzeugt werden können. Zwar ist die dem zu messenden Strom proportionale Ausgangsspannung nicht massebezogen, jedoch ist die Weiterverarbeitung sogenannter schwimmender Spannungen mit einem Differenzverstärker unproblematisch.

Bei einer Weiterbildung der Erfindung ist vorgesehen, daß die Verstärker jeweils einen Operationsverstärker aufweisen, daß die nicht-invertierenden Eingänge der Operationsverstärker mit einem Referenzpotential verbunden sind und daß die Spannungsversorgung der Operationsverstärker jeweils unter zwischenschaltung eines ersten bzw. zweiten Widerstandes aus einem positiven Versorgungspotential bzw. einem Bezugspotential erfolgt. Weiterhin sind jeweils zwei Endstufentransistoren vorgesehen, deren Basisanschlüsse an die Versorgungsanschlüsse des jeweiligen Operationsverstärkers angeschlossen sind und somit über. den ersten Widerstand bzw. den zweiten Widerstand mit dem Versorgungspotential bzw. dem Bezugspotential gekoppelt sind.

Der Emitter des jeweils einen Endstufentransistors, der vom einen Leitungstyp ist, ist an das Versorgungspotential und der jeweils andere Endstufentransistor, der vom anderen Leitungstyp ist, ist an das Bezugspotential angeschlossen. Dabei sind die Kollektoren beider Endstufentransistoren - den Ausgang des jeweiligen Verstärkers und damit einen Ausgang der Treiberschaltung bildend - miteinander gekoppelt, wobei die Sekundärwicklung und der.in Reihe dazu geschaltete Abschlußwiderstand zwischen die gekoppelten Emitter der Endstufen- . transistoren des einen Verstärkers einerseits und die gekoppelten Emitter der Endstufentransistoren des anderen Verstarkers andererseits geschaltet sind. Schließlich ist der invertierende Eingang eines der Operationsverstärker an den Ausgang der Auswerteschaltung angeschlossen und der invertierende Eingang des anderen Operationsverstärkers an den'Eingang oder Ausgang des einen Operationsverstärkers angeschlossen. Der Vorteil besteht darin, daß durch den Ruhestrom des jeweiligen Operationsverstärkers bereits eine Basis-Emitter-Vorspannung für die zugehörigen Endstufentransistoren an den entsprechend dimensionierten Widerständen entsteht. Dadurch wird der Übernahmebereich bereits stark verkleinert, ohne daß in den Endstufentransistoren ein Ruhestrom fließt und ohne daß zusätzliche Maßnahmen ergriffen werden müßten.

Bevorzugt wird dabei zwischen die gekoppelten Emitter der Endstufentransistoren und den Ausgang des einen Operationsverstärkers sowie zwischen die gekoppelten Emitter der Endstufentransistoren und den Ausgang des anderen Operationsverstärkers jeweils ein dritter Widerstand geschaltet. Bei kleinen Ausgangsströmen sind jeweils die beiden Endstufentransistoren gesperrt und der jeweilige Operationsverstärker erbringt den Ausgangsstrom. Bei größeren Ausgangsströmen werden sie leitend und liefern den größten Teil des Ausgangsstromes.

Bevorzugt wird zwischen Sensor und Treiberschaltung eine Auswerteschaltung zur Aufbereitung des vom Sensor bereitgestellten Meßwertes geschaltet. Damit läßt sich vorteilhafterweise das Ausgangssignal des Sensors an die jeweiligen eingangsseitigen Erfordernisse der Treiberschaltung anpassen.

Die Erfindung wird nachfolgend anhand der in den Figuren der Zeichnung dargestellten Ausführungsbeispiele näher erläutert. Es zeigt:

Figur 1    ein erstes allgemeines Ausführungsbeispiel eines erfindungsgemäßen Stromsensors,

Figur 2    ein zweites allgemeines Ausführungsbeispiel eines erfindungsgemäßen Stromsensors,

Figur 3    ein drittes allgemeines Ausführungsbeispiel eines erfindungsgemäßen Stromsensors,

Figur 4    ein viertes Ausführungsbeispiel betreffend eine bevorzugte Ausführungsform eines erfindungsgemaßen Stromsensors,

Figur 5    einen Stromsensor nach dem Stande der Technik.

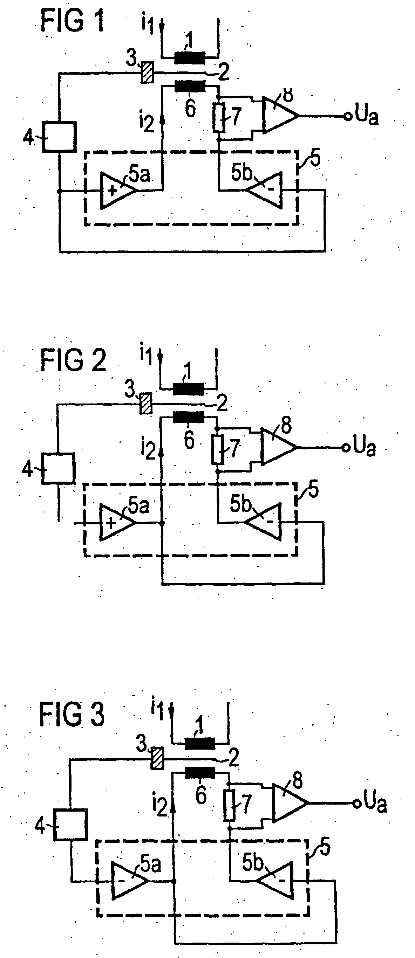

Bei der Ausführungsform nach Figur 1 wird ein zu messender Strom $i_1$ durch eine Primärwicklung 1 eines Stromtransformators geleitet, der zudem einen Magnetkern 2 sowie eine über den Magnetkern 2 magnetisch gekoppelte Sekundärspule 6 aufweist. Ein Sensor 3 ist dabei derart mit dem Magnetkern 2 gekoppelt, daß er den Magnetfluß im Magnetkern 2 mißt. Der Sensor 3 besteht beispielsweise aus einem in die Sättigung gesteuerten Transformator mit rechteckförmiger Magnetisierungskennlinie oder einem Hall'-Sensor. Eine dem Sensor nachgeschaltete Auswerteschaltung 4 bereitet den vom Sensor 3 gelieferten linearen Meßwert auf und leitet den aufbereiteten, beispielsweise verstärkten und gefilterten Meßwert an eine Treiberschaltung 5 weiter. Die Treiberschaltung 5 umfaßt dabei einen nicht-invertierenden Verstärker 5a und einen invertierenden Verstärker 5b, deren Eingänge einander parallel geschaltet und an den Ausgang der Auswerteschaltung 4 angeschlossen sind. Zwischen die Ausgänge der Verstärker 5a und 5b ist die Reihenschaltung aus, Sekundärwicklung 6 und Abschlußwiderstand 7 geschaltet. Die über dem Widerstand 7 abfallende, dem zu messenden Strom $i_1$ proportionale Spannung wird mittels eines Differenzverstärkers 8 abgenommen und steht an dessen Ausgang als eine beispielsweise auf ein Bezugspotential G bezogene Ausgangsspannung Ua zur Verfügung.

Gegenüber der Ausführungsform nach Figur 1 ist. diejenige aus Figur 2 dahingehend abgeändert, daß der Eingang des invertierenden Verstärkers 5b nicht dem Eingang des nicht-invertierenden Verstärkers 5a parallel geschaltet ist, sondern an dessen Ausgang angeschlossen ist. Die Ausführungsform nach. Figur 3 geht nun ihrerseits aus der Ausführungsform nach Figur 2 dadurch hervor, daß anstelle des nicht-invertierenden Verstärkers 5a ein invertierender Verstärker 5c vorgesehen ist.

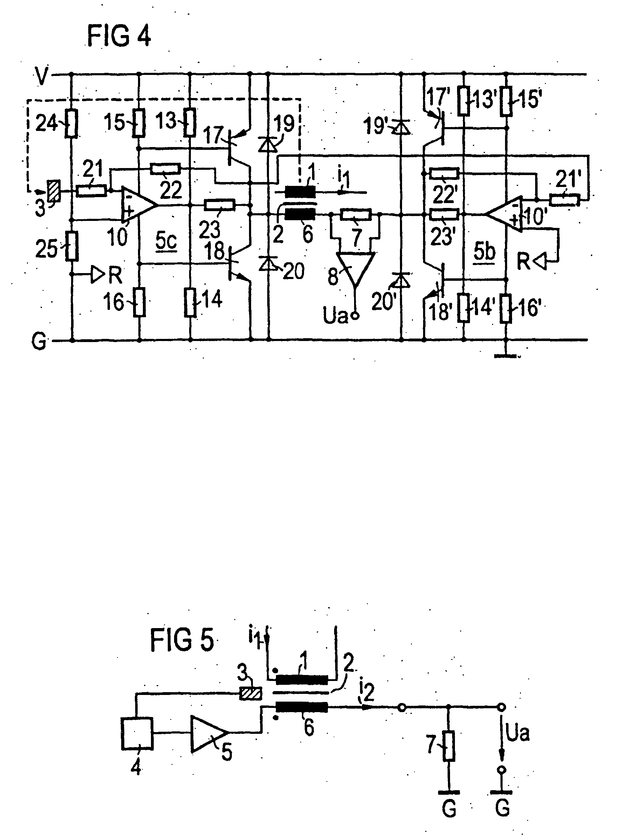

Gemäß Figur 4 enthält die Treiberschaltung 5 aus Figur 3 bevorzugt einen Operationsverstärker 10, dessen invertierender Eingang zum einen über einen Widerstand 21 an den Sensor 3 angeschlossen ist (Auswerteschaltung 4 kann hierbei beispielsweise entfallen) und zum anderen über einen Widerstand 12 mit seinem Ausgang gekoppelt ist. Dessen nicht- invertierender Eingang ist zum einen über einen Widerstand 25 mit dem Bezugspotential G und zum anderen über einen Widerstand 24 ein Referenzpotential R bildend verbunden. Der Operationsverstärker 10 ist somit mit den Widerständen 21 und 22 als invertierender Verstärker 5c beschaltet. Der Ausgang des Operationsverstärkers 10 ist darüber hinaus über einen Widerstand 13 mit einem positiven Versorgungspotential V und über einen Widerstand 14 mit dem Bezugspotential G gekoppelt. Die beiden Widerstände 13 und 14 können jedoch auch gegebenenfalls entfallen. Die Spannungsversorgung des Operationsverstärkers 10 erfolgt jeweils unter Zwischenschaltung eines Widerstandes 15 bzw. 16 aus einem positiven. Versorgungspotential V bzw. dem Bezugspotential G. Die beiden Spannungsversorgungszweige dienen darüber hinaus zur Ansteuerung zweier Endstufentransistoren 17 und 18. Deren Basisanschlüsse sind jeweils an die Versorgungsanschlüsse des Operationsverstärkers 10 angeschlossen und somit über den Widerstand 15 bzw. den Widerstand 16 mit dem positiven Versorgungspotential V bzw. dem Bezugspotential G gekoppelt. Der Emitter des Transistors 17, der vom pnp-Typ ist, ist an das positive Versorgungspotential V und der Transistor 18, der vom npn-Typ ist, ist an das Bezugspotential G angeschlossen. Die Kollektoren der beiden Transistoren 17 und 18 sind - den Ausgang der Gegentaktendstufe und damit einen Ausgang der Treiberschaltung 5 bildend - miteinander gekoppelt und über jeweils eine als Freilaufdiode wirkende Diode 19 bzw. 20 in Sperrichtung an das positive Versorgungspotential V bzw. an das dem Bezugspotential G angeschlossen. Schließlich ist ein Widerstand 23 zwischen den Ausgang des Operationsverstärkers 10 und die gekoppelten Kollektoren der Transistoren 17 und 18 geschaltet.

Darüber hinaus ist eine identisch aufgebaute, weitere Gegentaktendstufe mit den Transistoren 17' und 18', mit den Dioden 19' und 20', den Widerständen 13' bis 16', 21' bis 25' sowie einem Operationsverstärkers 10' vorgesehen. Die Sekundärwicklung 6 und der in Reihe dazugeschaltete Abschlußwiderstand 7 sind dabei zwischen die gekoppelten Emitter der Transistoren 17 und 18 einerseits und die gekoppelten Emitter der Transistoren 17' und 18' andererseits geschaltet. Der nicht invertierende Eingang des Operationsverstärkers 10 ist schließlich an ein Referenzpotential R und dessen invertierender Eingang ist unter Zwischenschaltung eines Widerstandes 23 an den Ausgang des Operationsverstärkers 10 angeschlossen.

Durch die Sekundärwicklung 6 und den Abschlußwiderstand 7 wird dabei ein Strom $i_2$ geleitet, der zum einen den durch den . Strom $i_1$ hervorgerufenem Magnetfluß im Magnetkern 2 kompensieren und zum anderen einen Spannungsabfall über dem Abschlußwiderstand 7 erzeugen soll. Der Spannungsabfall über dem Widerstand 7 bildet dabei die Eingangsgröße für den Differenzverstärker 8, an dessen Ausgang die dem zu messenden Strom $i_1$ proportionale Spannung U anliegt. Bei der Ausführungsform nach Figur 4 wird nur eine unipolare Spannungsversorgung verwendet. Bei gleichen Eigenschaften wie bipolar gespeiste der Stromsensor benötigt der Stromsensor lediglich die halbe Versorgungsspannung.

**Patentansprüche**

1. Stromsensor nach dem Kompensationsprinzip bei dem das von einer vom zu messenden Strom durchflossenen Primärwicklung (1) erzeugte Magnetfeld durch den Kompensationsstrom in einer Sekundärwicklung (6) kompensiert wird und bei dem zur Steuerung des Kompensationsstromes mindestens ein vom Magnetfeld beeinflußter Sensor (3) Abweichungen vom Nullfluß erfaßt und diesen Meßwert einer Treiberschaltung (5) zur Erzeugung des Kompensationsstromes zuführt, wobei an den Ausgang der Treiberschaltung (5) die Sekundärwicklung (6) in Reihe zu einem Abschlußwiderstand (7) angeschlossen ist und am Abschlußwiderstand (7) eine dem zu messenden Strom proportionale Spannung (Ua) anliegt,
   **dadurch gekennzeichnet, daß** als Treiberschaltung (5) zwei durch den Meßwert angesteuerte, einander gegenüber gegenphasige Ausgangssignale liefernde, an eine unipolare Spannungsversorgung angeschlossene Verstärker (5a, 5b) in Brückenschaltung verwendet werden, wobei zwischen die Ausgänge der Verstärker die Reihenschaltung aus Sekundärwicklung (6) und Abschlußwiderstand (7) geschaltet ist.

2. Stromsensor nach Anspruch 1,
   **dadurch gekennzeichnet, daß** die Treiberschaltung (5) zwei Gegentaktendstufen (13 bis 20, 13' bis 20'; 28 bis 31; 32 bis 35) als Verstärker (5a, 5b) aufweist.

3. Stromsensor nach Anspruch 1,
   **dadurch gekennzeichnet**,

   daß die Verstärker (5a, 5b) jeweils einen Operationsverstärker (10, 10') aufweisen,

daß der nicht-invertierende Eingang jedes Operationsverstärkers (10, 10') mit einem Referenzpotential (R). verbunden ist, daß die Spannungsversorgung jedes Operationsverstärkers (10, 10') jeweils unter Zwischenschaltung eines ersten bzw. zweiten Widerstandes (15; 15', 16; 16') aus einem Versorgungspotential (V) bzw. einem Bezugspotential (G) erfolgt, daß zwei Endstufentransistoren (17, 17', 18, 18') vorgesehen sind, deren Basisanschlüsse jeweils an die Versorgungsanschlüsse des jeweiligen Operationsverstärkers (10, 10') angeschlossen sind und somit über den ersten Widerstand (15, 15') mit dem Versorgungspotential (V) und über den zweiten Widerstand (16, 16') mit dem Bezugspotential (G) gekoppelt sind,

daß der Emitter des jeweils einen Endstufentransistors (17, 17'), der vom einen Leitungstyp ist, an das Versorgungspotential (V) und der jeweils andere Endstufentransistor (18, 18'), der vom anderen Leitungstyp ist, an das Bezugspotential (G) angeschlossen ist,

daß die Kollektoren jeweils beider Endstufentransistoren (17, 17'; 18 18') - den Ausgang des jeweiligen Verstärkers (5a, 5b) und damit einen Ausgang der Treiberschaltung (5) bildend - miteinander gekoppelt sind,

daß die Sekundärwicklung (6) und der in Reihe dazu geschaltete Abschlußwiderstand (7) zwischen die gekoppelten Kollektoren der Endstufentransistoren (17, 18) des einen Verstärkers (5c) einerseits und die gekoppelten Kollektoren der Endstufentransistoren (17', 18') des anderen Verstärkers (5a) andererseits geschaltet sind,

daß der invertierende Eingang eines der Operationsverstärker (10) durch den vom Sensor 3 bereitgestellten Meßwert angesteuert wird und daß der invertierende Eingang des anderen Operationsverstärkers (10') an den Eingang oder Ausgang des einen Operationsverstärkers (10) angeschlossen ist.

4. Stromsensor nach einem der Ansprüche 1 bis 3, **dadurch gekennzeichnet, daß** zwischen die gekoppelten Kollektoren der Endstufentransistoren 17 und 18 und den Ausgang des einen Operationsverstärkers (10) sowie zwischen die gekoppelten Emitter der Endstufentransistoren 17' und 18' und den Ausgang des anderen Operationsverstärkers (10') jeweils dritter Widerstand (23, 23') geschaltet ist.

5. Stromsensor nach einem der Ansprüche 1 bis 4, **dadurch gekennzeichnet, daß** eine Auswerteschaltung (4) zur Aufbereitung des vom Sensor (3) bereitgestellten Meßwertes zwischen Sensor (3) und Treiberschaltung (5) geschaltet ist.

**Claims**

1. Current sensor operating in accordance with the principle of compensation, in which the magnetic field generated by a primary winding (1) through which the current to be measured flows is compensated for in a secondary winding (6) by the compensating current and in which, in order to control the compensating current, at least one sensor (3) influenced by the magnetic field detects deviations from the null flux and supplies this measured value to a drive circuit (5) in order to generate the compensating current, the secondary winding (6) being connected to the output of the drive circuit (5) in series with a terminating resistor (7) and a voltage (Ua) proportional to the current to be measured being applied to the terminating resistor (7), **characterised in that** two amplifiers (5a, 5b) driven by the measured value, supplying output signals in phase opposition and connected to a unipolar voltage supply are bridge-connected and used as the drive circuit (5), the series connection consisting of the secondary winding (6) and the terminating resistor (7) being connected between the outputs of the amplifiers.

2. Current sensor according to claim 1, **characterised in that** the drive circuit (5) has two push-pull output stages (13 to 20, 13' to 20'; 28 to 31; 32 to 35) serving as the amplifiers (5a, 5b).

3. Current sensor according to claim 1, **characterised in that** the amplifiers (5a, 5b) each have an operational amplifier (10, 10'), that the non-inverting input of each operational amplifier (10, 10') is connected to a reference potential (R), that the voltage is supplied to each operational amplifier (10, 10') from a supply potential (V) or a reference potential (G) with the interconnection of a first or second resistor (15; 15', 16; 16') respectively, that two power transistors (17, 17', 18, 18') are provided, their base terminals each being connected to the supply terminals of the respective operational amplifier (10, 10') and therefore being coupled via the first resistor (15, 15') to the supply potential (V) and via the second resistor (16, 16') to the reference potential (G), that the emitter of one power transistor (17, 17') of one conduction type is connected to the supply potential (V) and the other power transistor (18, 18') of the other conduction type is connected to the reference potential (G), that the collectors of the two power transistors (17, 17'; 18, 18') forming the output of the respective amplifier (5a, 5b) and therefore an output of the drive circuit (5) are coupled together, that the secondary winding (6) and the terminating resistor (7) connected in series therewith are connected, between, on the one hand, the coupled collectors of the power transistors (17, 18) of one amplifier (5c) and, on the other hand, the coupled collectors of the power transistors (17', 18') of the other amplifier (5a), that the inverting input of one of the operational amplifiers (10) is driven by the measured value provided by the sensor 3 and that the inverting input of the second operational amplifier (10') is connected to the input or output of the first operational amplifier (10).

4. Current sensor according to one of claims 1 to 3, **characterised in that** a respective third resistor (23, 23') is connected between the coupled collectors of the power transistors 17 and 18 and the output of one operational amplifier (10) and between the coupled emitters of the power transistors 17' and 18' and the output of the other operational amplifier (10').

5. Current sensor according to one of claims 1 to 4, **characterised in that** an evaluation circuit (4) is connected between the sensor (3) and the drive circuit (5) in order to process the measured value provided by the sensor (3).


## Revendications

1. Détecteur de courant fonctionnant suivant le principe de compensation dans lequel le champ magnétique produit par un enroulement (1) primaire dans lequel passe le courant à mesurer est compensé par le courant de compensation dans un enroulement (6) secondaire et dans lequel, pour commander le courant de compensation, au moins un détecteur (3) influencé par le champ magnétique détecte des écarts par rapport au flux zéro et envoie cette valeur de mesure à un circuit (5) d'attaque pour la production du courant de compensation, l'enroulement (6) secondaire étant monté, à la sortie du circuit (5) d'attaque, en série avec une résistance (7) de terminaison et une tension (Ua) proportionnelle au courant à mesurer s'appliquant à la résistance (7) de terminaison,

   **caractérisé en ce qu'**il est utilisé comme circuit (5) d'attaque deux amplificateurs (5a, 5b) en circuit en pont, commandés par la valeur de mesure, fournissant des signaux de sortie en opposition de phase l'un par rapport à l'autre et reliés à une alimentation en courant monopolaire, le circuit série constitué de l'enroulement (6) secondaire et de la résistance (7) de terminaison étant branché entre les sorties des amplificateurs.

2. Détecteur de courant suivant la revendication 1, **caractérisé en ce que** le circuit (5) d'attaque comporte comme amplificateurs (5a, 5b) deux étages (13 à 20, 13'à 20'; 28 à 31; 32 à 35) en push-pull.

3. Détecteur de courant suivant la revendication 1, **caractérisé en ce que** les amplificateurs (5a, 5b) comportent respectivement un amplificateur (10, 10') opérationnel,

   en ce que l'entrée non inverseuse de chaque amplificateur (10, 10') opérationnel est reliée à un potentiel (R) de référence,
   en ce que l'alimentation en tension de chaque amplificateur (10, 10') opérationnel s'effectue respectivement avec interconnexion d'une première respectivement deuxième résistance (15 ; 15', 16 ; 16') à partir d'un potentiel (V) d'alimentation et d'un potentiel (G) de référence,
   en ce qu'il est prévu deux transistors (17, 17', 18, 18') d'étage d'extrémité dont les bornes de base sont raccordées respectivement aux bornes d'alimentation de l'amplificateur (10, 10') opérationnel associé et sont ainsi couplées par l'intermédiaire de la première résistance (15, 15') au potentiel (V) d'alimentation et par l'intermédiaire de la deuxième résistance (16, 16') au potentiel (G) de référence,
   en ce que l'émetteur de l'un des transistors (17, 17') d'étage d'extrémité, qui est d'un type de conductivité, est raccordé au potentiel (V) d'alimentation et l'autre transistor (18, 18') d'étage d'extrémité, qui est de l'autre type de conductivité est raccordé au potentiel (G) de référence,
   en ce que les collecteurs respectivement des deux transistors (17, 17'; 18, 18') d'étage d 'extrémité sont couplés l'un à l'autre - formant la sortie de l'amplificateur (5a, 5b) respectif et donc une sortie du circuit (5) d'attaque,
   en ce que l'enroulement (6) secondaire et la résistance (7) de terminaison montée en série avec cet enroulement sont branchés entre les collecteurs couplés des transistors (17, 18) d'étage d'extrémité de l'un (5c) des amplificateurs, d'une part, et les collecteurs couplés des transistors (17', 18') d'étage d'extrémité de l'autre amplificateur (5a), d'autre part,
   en ce que l'entrée inverseuse de l'un (10) des amplificateurs opérationnels est commandée par la valeur de mesure mise à disposition par le détecteur (3) et
   en ce que l'entrée inverseuse de l'autre amplificateur (10') opérationnel est raccordée à l'entrée ou à la sortie de l'un (10) des amplificateurs opérationnels.

4. Détecteur de courant suivant l'une des revendications 1 à 3, **caractérisé en ce qu'**il est monté entre les collecteurs couplés des transistors (17 et 17) d'étage d'extrémité et la sortie de l'un (10) des amplificateurs opérationnels, ainsi qu'entre les émetteurs couplés des transistors (17' et 18') d'étage d'extrémité et la sortie de l'autre amplificateur (10') opérationnel respectivement une troisième résistance (23, 23').

5. Détecteur de courant suivant l'une des revendications 1 à 4, **caractérisé en ce qu'**un circuit (4) d'exploitation pour la préparation de la valeur de mesure mise à disposition par le détecteur (3) est monté entre le détecteur (3) et le circuit (5) d'attaque.

FIG 1

FIG 2

FIG 3

## FIG 4

## FIG 5